# EUROPEAN PATENT SPECIFICATION

(11) **EP 3 229 355 B1**
(45) Date of publication and mention of the grant of the patent: **10.01.2024**
(21) Application number: 15865581.1
(22) Date of filing: 25.11.2015
(51) Int. Cl.: H02M 1/08, H03K 17/00, H03K 17/687, H03K 17/0412, H03K 17/0812, H03K 17/18

(54) **LOAD DRIVING DEVICE AND IN-VEHICLE CONTROL DEVICE USING SAME**
LASTANTRIEBSVORRICHTUNG UND FAHRZEUGINTERNE STEUERUNGSVORRICHTUNG DAMIT
DISPOSITIF D'ATTAQUE DE CHARGE ET DISPOSITIF DE COMMANDE EMBARQUÉ L'UTILISANT

(30) Priority: 05.12.2014 JP 2014246404
(43) Date of publication of application: 11.10.2017
(73) Proprietor: Hitachi Astemo, Ltd., Hitachinaka-shi, Ibaraki 312-8503 (JP)
(72) Inventor: SONEHARA, Masahito, Hitachinaka-shi Ibaraki 312-8503 (JP); KOBAYASHI, Youichirou, Hitachinaka-shi Ibaraki 312-8503 (JP)
(74) Representative: MERH-IP Matias Erny Reichl Hoffmann Patentanwälte PartG mbB
(86) International application number: PCT/JP2015/082969
(87) International publication number: WO 2016/088607

(56) References cited:
- EP-A2- 0 517 261
- JP-A- H07 194 118
- JP-A- 2003 143 833
- JP-A- 2008 022 451
- JP-A- 2008 147 923
- JP-A- 2011 071 174
- JP-A- 2012 165 618
- JP-A- 2014 117 044
- JP-A- 2014 120 625
- US-A1- 2012 188 001
- US-A1- 2014 253 184

## Description

### Technical Field

The present invention relates to a load driving device and an in-vehicle control device using the same.

### Background Art

Conventionally, there is a tendency toward electronic control of various units mounted on a vehicle . Along with this, to convert an electric signal into a mechanical motion or hydraulic pressure, an electric actuator such as a motor and a solenoid has widely been used. The electric actuator and a control device controlling the electric actuator are supplied from an in-vehicle battery with electric power whose voltage value is raised or lowered by a power source circuit such as a switching regulator. Each of the electric actuator and the switching regulator is configured to drive a load by controlling ON/OFF of a switching element such as a power metal-oxide-semiconductor field-effect transistor (MOSFET) and an insulated gate bipolar transistor (IGBT) by applying voltage to a gate terminal of the switching element. For this reason, to control each of the electric actuator and the switching regulator safely, voltage needs to be applied to the gate terminal of the switching element correctly.

On the other hand, the probability of a failure of a gate oxide film forming the gate terminal is proportional to the area of the switching element. Since a device, such as the electric actuator and the switching regulator, that needs to drive high current, includes the switching element having a large area, the probability of a failure is high.

Accordingly, in in-vehicle application, which requires high reliability, a general way to solve the problem is to eliminate an element having a failure in the gate oxide film before shipment by accelerating the duration of the gate oxide film in a stress test (voltage stress, temperature stress, and stress application time) in a manufacture process and measuring gate leak current before and after stress application.

However, in a case of breakdown of the gate oxide film or electrostatic breakdown caused by a surge generated during the operation of the switching element after shipment, a failure of the gate oxide film cannot be detected.

A load driving device described in PTL 1 applies a driving signal to a semiconductor switching element via a gate resistor connected to a gate terminal of the semiconductor switching element and includes a gate current measurement means configured to measure gate current flowing in the gate resistor, a normality/abnormality determination means configured to determine normality or abnormality by comparing a gate current measurement value detected by the gate current measurement means and a normal range current value, a control means configured to receive an output signal of the normality/abnormality determination means and control a gate driving circuit of the semiconductor switching element, and an abnormal signal transmission means configured to transmit the output signal of the normality/abnormality determination means to the control means, and the normality/abnormality determination means compares a gate current measurement value for at least either gate current flowing in the gate resistor at the time of turn-on or gate current flowing in the gate resistor at the time of turn-off with the normal range current value to detect a failure of the switching element from abnormality of gate leak current during an operation of the load driving device. US 2014/0253184 A1 discloses a gate drive circuit which includes a power supply circuit that has an output switch function for switching a voltage value of a drive voltage between two levels, a gate-ON drive circuit that outputs a constant electric current toward a gate of an IGBT from an output terminal of the power supply circuit, and a control section performs a constant electric current drive of a gate of the IGBT at a time of a turn-ON by operating the gate-ON drive circuit. At a turn-ON start time, the control section sets the drive voltage to a relatively-high first set value, and then switches the drive voltage to a relatively-low second set value at a switch timing after a mirror period end time.
Further relevant prior art is described in JP 2012 165618 A and US 2012/188001 A1.

### Citation List

### Patent Literature

PTL 1: JP 2003-143833 A

### Summary of Invention

### Technical Problem

However, in PTL 1, since the gate resistor exists between a power source of the gate driving circuit and a gate of the semiconductor switching element, a high-speed switching operation of the gate terminal needs to be achieved. Specifically, PTL 1 describes that measurement is preferably performed after a lapse of 5 ps from turn-on or turn-off until no gate current flows. That is, a period of 5 us or longer is required until the gate voltage becomes stable, and the switching operation is completed after turn-on or turn-off. Thus, in a load driving device having a switching frequency of 100 kHz or higher, a period from turn-on to turn-off is shorter than 5 us, which is a period required until the gate voltage becomes stable, which thus causes an incomplete switching operation.

In this manner, in the conventional load driving device including the current measurement circuit for detection of a failure of the gate oxide film, a high-speed switching operation is not considered.

In consideration of the above problem, a main object of the present invention is to provide a load driving device enabling a failure of a gate oxide film to be detected even after shipment and including a gate current measurement circuit enabling a high-speed switching operation.

### Solution to Problem

To solve the above problem, the present invention provides a load driving having the features defined in claim 1. Moreover, it is provided an in-vehicle control device comprising the inventive load drive device. The in-vehicle control device has the features defined in claim 9 or in claim 12. Further preferred embodiments are defined in the dependent claims.

### Advantageous Effects of Invention

According to the present invention, it is possible to provide a load driving device enabling a failure of a gate oxide film to be detected even after shipment and including a gate current measurement circuit enabling a high-speed switching operation. Problems, configurations, and effects other than those described above will be apparent from the following description of embodiments.

### Brief Description of Drawings

[FIG. 1] FIG. 1 is a block diagram illustrating a configuration of a load driving device 100 according to a first embodiment of the present invention.
[FIG. 2] FIG. 2 is a block diagram illustrating an example of a configuration of a gate driving circuit 3 of the load driving device 100 according to the first embodiment of the present invention.
[FIG. 3] FIG. 3 is a block diagram illustrating an example of a configuration of a voltage application circuit 31 of the load driving device 100 according to the first embodiment of the present invention.
[FIG. 4] FIG. 4 is a block diagram illustrating another example of a configuration of the voltage application circuit 31 of the load driving device 100 according to the first embodiment of the present invention.
[FIG. 5] FIG. 5 is a block diagram illustrating an example of a configuration of a current measurement circuit 2 of the load driving device 100 according to the first embodiment of the present invention.
[FIG. 6] FIG. 6 is a block diagram illustrating another example of a configuration of the current measurement circuit 2 of the load driving device 100 according to the first embodiment of the present invention.
[FIG. 7] FIG. 7 is a timing chart illustrating an example of a circuit operation of the load driving device 100 according to the first embodiment of the present invention.
[FIG. 8] FIG. 8 is a block diagram illustrating an example of a configuration of a load driving device 100A serving as a modification example of the first embodiment of the present invention.
[FIG. 9] FIG. 9 is a block diagram illustrating an example of a configuration of a load driving device 100B serving as a modification example of the first embodiment of the present invention.
[FIG. 10] FIG. 10 is a block diagram illustrating an example of a configuration of a load driving device 100C serving as a modification example of the first embodiment of the present invention.
[FIG. 11] FIG. 11 is a block diagram illustrating an example of a configuration of the current measurement circuit 2 of a load driving device 101 according to a second embodiment of the present invention.
[FIG. 12] FIG. 12 is a timing chart illustrating an example of a circuit operation of the load driving device 101 according to the second embodiment of the present invention.
[FIG. 13] FIG. 13 is a block diagram illustrating an example of a configuration of a load driving device 102 according to a third embodiment of the present invention.
[FIG. 14] FIG. 14 is a block diagram illustrating an example of a configuration of a load control device 301 using the load driving device 102 according to the third embodiment of the present invention.
[FIG. 15] FIG. 15 is a block diagram illustrating an example of a configuration of a load driving device 103 according to a fourth embodiment of the present invention.
[FIG. 16] FIG. 16 is a block diagram illustrating an example of a configuration of a load driving device 104 according to a fifth embodiment of the present invention applied to a boost switching regulator 302.
[FIG. 17] FIG. 17 is a block diagram illustrating an example of a configuration of a load driving device 105 according to a sixth embodiment of the present invention applied to a buck switching regulator 303.

### Description of Embodiments

In each of the following embodiments, a configuration and an operation of a load driving device including a gate current measurement circuit enabling a high-speed switching operation will be described.

### (First Embodiment)

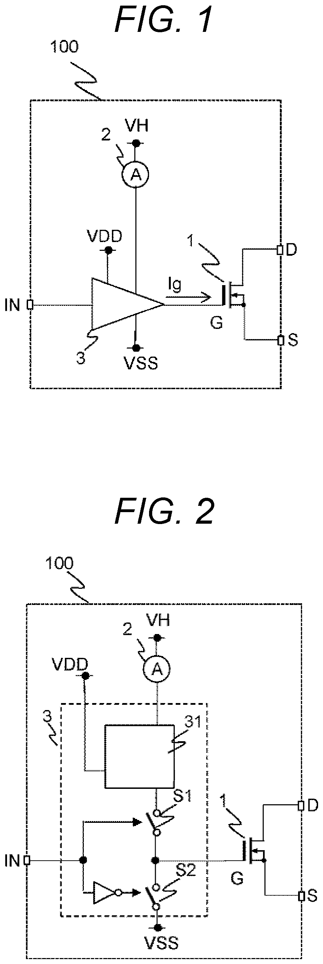

FIG. 1 is a block diagram illustrating a configuration of a load driving device 100 according to a first embodiment of the present invention. The load driving device 100 illustrated in FIG. 1 includes a switching element 1 serving as an NMOS and including a drain terminal D, a source terminal S, and a gate terminal G, a gate driving circuit 3 connected at an input thereof to an IN terminal of the load driving device 100 to output voltage to the gate terminal G of the switching element 1, and a current measurement circuit 2 configured to measure gate current Ig of the switching element 1 flowing via the gate driving circuit 3 from a power source VH.

When rated voltage to be applied to the gate when the switching element 1 is in an on state is VDD, and rated voltage to be applied to the gate when the switching element 1 is in an off state is VSS, the gate driving circuit 3 uses as a power source the power source VH having higher potential than the power source VDD to output to the gate terminal G of the switching element 1 voltage restricted to be within a rated voltage range from VSS to VDD.

FIG. 2 is a block diagram illustrating a configuration of the gate driving circuit 3 of the load driving device 100 according to the first embodiment of the present invention. The gate driving circuit 3 illustrated in FIG. 2 includes a voltage application circuit 31 configured to use the VH as a power source to output voltage restricted to voltage of VDD or lower, a switch S1 configured to output an output of the voltage application circuit to the gate terminal G of the switching element 1, and a switch S2 configured to output voltage from the power source VSS to the gate terminal G of the switching element 1. The switch S1 and the switch S2 are exclusively turned on or off in accordance with the input IN terminal of the load driving device 100.

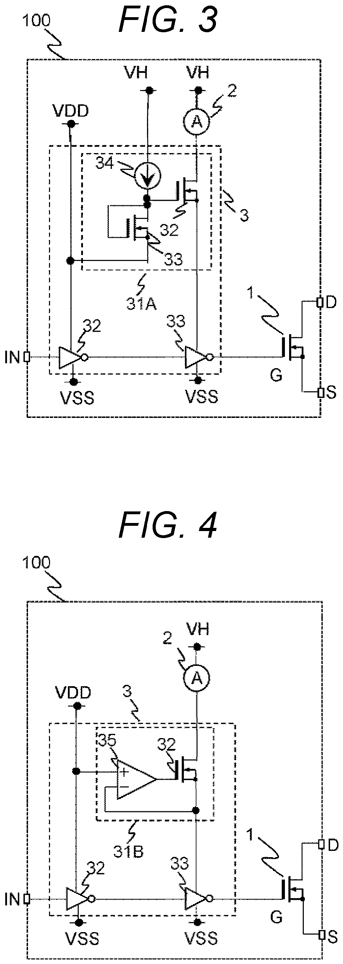

FIGS. 3 and 4 are block diagrams illustrating configuration examples of the gate driving circuit 3 and the voltage application circuit 31 of the load driving device 100 according to the first embodiment of the present invention.

The gate driving circuit 3 illustrated in FIG. 3 includes an inverter 32 connected to the IN terminal and configured to use the VDD and the VSS as power sources, a voltage application circuit 31A configured to use the VH as a power source and the VDD as a reference power source to output voltage having equal potential to that of the VDD, and an inverter 33 configured to use an output of the voltage application circuit 31A and the VSS as power sources.

The voltage application circuit 31A includes an NMOS 32, an NMOS 33, and a current source 34, and by adjusting sizes of the NMOS 33 and the current source 34 so that the NMOS 32 may output voltage having source potential equal to the potential of the VDD, the gate driving circuit 3 outputs voltage whose output range is restricted to be within a range from VSS to VDD with a simple configuration. Also, the current measurement circuit 2 can measure only gate current of the switching element 1 flowing from the power source VH.

The gate driving circuit 3 illustrated in FIG. 4 includes the inverter 32 connected to the IN terminal and configured to use the VDD and the VSS as power sources, a voltage application circuit 31B configured to use the VH as a power source and the VDD as a reference power source to output voltage having equal potential to that of the VDD, and the inverter 33 configured to use an output of the voltage application circuit 31B and the VSS as power sources. The voltage application circuit 31B includes an operational amplifier 35 and the NMOS 32, and by performing feedback control so that the source potential of the NMOS 32 may be equal to the potential of the VDD power source, the gate driving circuit 3 can restrict the voltage output range thereof to a range from VSS to VDD with high accuracy. Also, the current measurement circuit 2 can measure only gate current of the switching element 1 flowing from the power source VH.

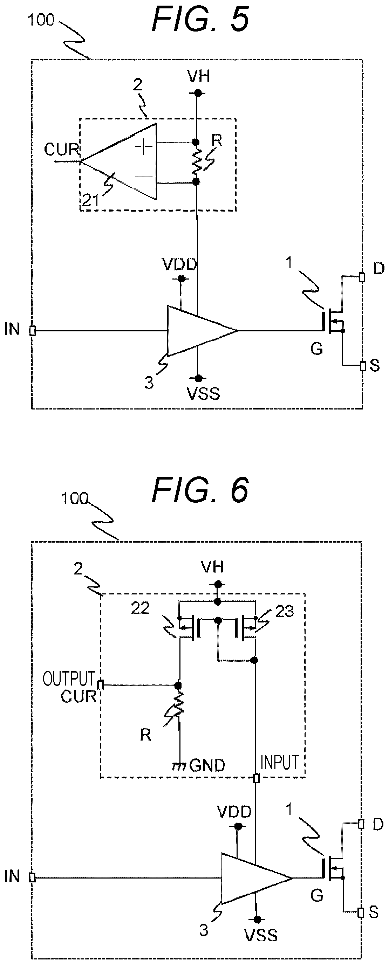

FIG. 5 is a block diagram illustrating an example of a configuration of the current measurement circuit 2 of the load driving device 100 according to the first embodiment of the present invention. The current measurement circuit 2 includes a current detection resistor R and a calculation circuit 21 configured to amplify and output a potential difference between terminals of the current detection resistor R and outputs a voltage value CUR derived by multiplying current flowing from the power source VH to the gate terminal of the switching element 1 by resistance of the current detection resistor R.

FIG. 6 is a block diagram illustrating another example of a configuration of the current measurement circuit 2 of the load driving device 100 according to the first embodiment of the present invention. The current measurement circuit 2 includes a PMOS 22, a PMOS 23, and the current detection resistor R. The PMOS 22 and the PMOS 23 constitutes a current mirror. The current mirror of the current measurement circuit 2 receives current flowing from the power source VH via the gate driving circuit 3 into the gate terminal of the switching element 1 to output current amplified by the size ratio of the PMOS 22 to the PMOS 23. The current detection resistor R is connected at one terminal thereof to an output of the current mirror and at the other terminal thereof to a GND and outputs the voltage value CUR derived by multiplying output current of the current mirror by a resistance value of the current detection resistor R. Since the current measurement circuit 2 in FIG. 6 outputs voltage with reference to the GND, the current measurement circuit 2 in FIG. 6 exerts an effect of simplifying a circuit that receives an output of the current measurement circuit further than the current measurement circuit 2 in FIG. 5.

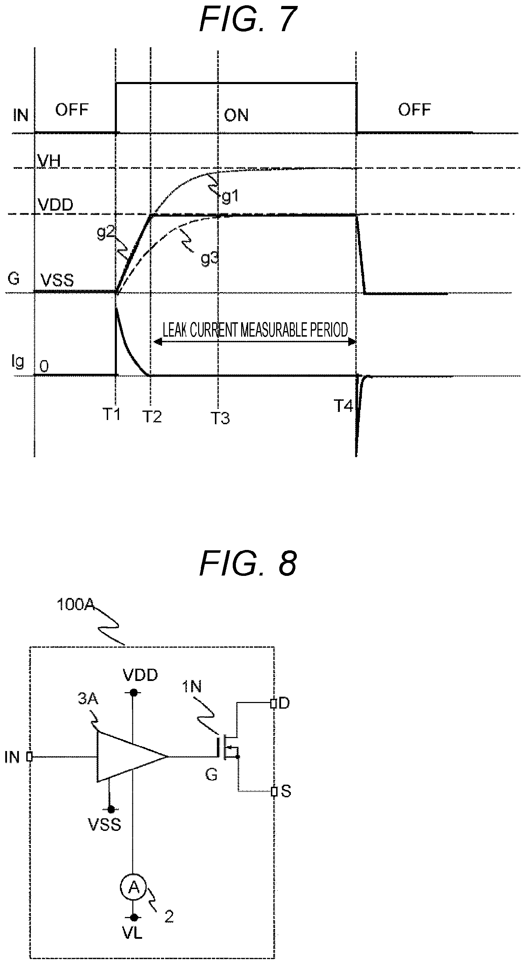

FIG. 7 is a timing chart illustrating an example of a circuit operation according to the first embodiment of the present invention. The timing chart in FIG. 7 illustrates the IN terminal for turn-on and turn-off of the load driving device 100, the gate terminal of the switching element 1, and the current Ig of the gate terminal. When the IN terminal changes from OFF to ON at time T1, voltage of the gate terminal of the switching element 1 rises from the potential of the power source VSS to approach asymptotically to the potential of the power source VH as illustrated by a gate voltage waveform g1 and is restricted to the output voltage of the voltage application circuit 31.

For example, in a case of the voltage application circuit 31B in FIG. 4, as illustrated by a gate voltage waveform g2, voltage of the gate terminal reaches the voltage of the power source VDD at time T2 and is restricted to VDD, and the switching element 1 is in an on state. As for the gate current Ig, charging current to a gate capacity of the switching element 1 is generated from time T1 to time T2, and at or after time T2, at which voltage reaches VDD, the gate current Ig is approximately equivalent to zero in a case of a normal switching element. Accordingly, when the value of gate leak current, which is current at and after time T2, is abnormal, a failure of a gate oxide film of the switching element 1 can be detected.

Also, in a case in which the potential of the power source VH is equal to the potential of the power source VDD, voltage of the gate terminal rises to approach asymptotically to the potential of the power source VDD as illustrated by a gate voltage waveform g3, and the switching element 1 is thus in an on state at time T3. Accordingly, a larger potential difference between the power source VH and the power source VDD brings about an effect of shortening turn-on time and enables high-speed switching. Also, even in a case in which the potential difference between the power source VH and the power source VDD is large, voltage of the gate terminal is restricted to the output voltage of the voltage application circuit 31, and it is thus possible to restrict voltage to be applied to the gate terminal G of the switching element 1 from exceeding the rated voltage range.

On the other hand, in the load driving circuit in FIG. 4, in a case in which the IN terminal changes from ON to OFF at time T4, turn-off can be performed in a short period. However, since there is no current measurement circuit between the switching element 1 and the power source VSS, gate current cannot be detected.

FIGS. 8 to 10 are configuration examples into which the load driving device 100 according to the first embodiment of the present invention has been modified. Although each of the configuration examples in FIGS. 1 and 8 to 10 can be achieved by itself, combination of FIGS. 1 and 8 and FIGS. 9 and 10 enables measurement of the gate leak current both at the time of turn-on and at the time of turn-off. Similarly, in second and subsequent embodiments, combination is available.

A load driving device 100A illustrated in FIG. 8 includes a switching element 1N serving as an NMOS and including the drain terminal D, the source terminal S, and the gate terminal G, a gate driving circuit 3A connected at an input thereof to the IN terminal of the load driving device 100A to output voltage to the gate terminal G of the switching element 1N, and the current measurement circuit 2 configured to measure gate current Ig of the switching element 1 flowing via the gate driving circuit 3A from a power source VL having lower potential than the power source VSS. Accordingly, by measuring gate leak current when the switching element 1N is in an off state, a failure of the gate oxide film can be detected.

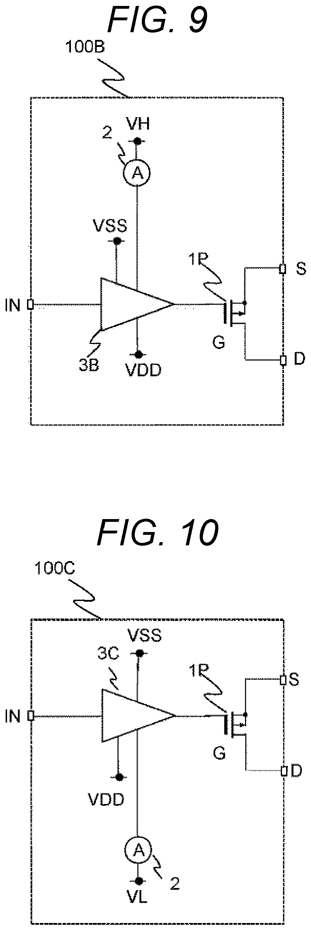

A load driving device 100B illustrated in FIG. 9 includes a switching element 1P serving as a PMOS and including the drain terminal D, the source terminal S, and the gate terminal G, a gate driving circuit 3B connected at an input thereof to the IN terminal of the load driving device 100B to output voltage to the gate terminal G of the switching element 1P, and the current measurement circuit 2 configured to measure gate current Ig of the switching element 1P flowing via the gate driving circuit 3B from the power source VH having higher potential than the power source VDD. Accordingly, by measuring gate leak current when the switching element 1P is in an off state, a failure of the gate oxide film can be detected.

A load driving device 100C illustrated in FIG. 10 includes the switching element 1P serving as a PMOS and including the drain terminal D, the source terminal S, and the gate terminal G, a gate driving circuit 3C connected at an input thereof to the IN terminal of the load driving device 100C to output voltage to the gate terminal G of the switching element 1P, and the current measurement circuit 2 configured to measure gate current Ig of the switching element 1P flowing via the gate driving circuit 3C from the power source VL having lower potential than the power source VSS . Accordingly, by measuring gate leak current when the switching element 1P is in an on state, a failure of the gate oxide film can be detected.

### (Second Embodiment)

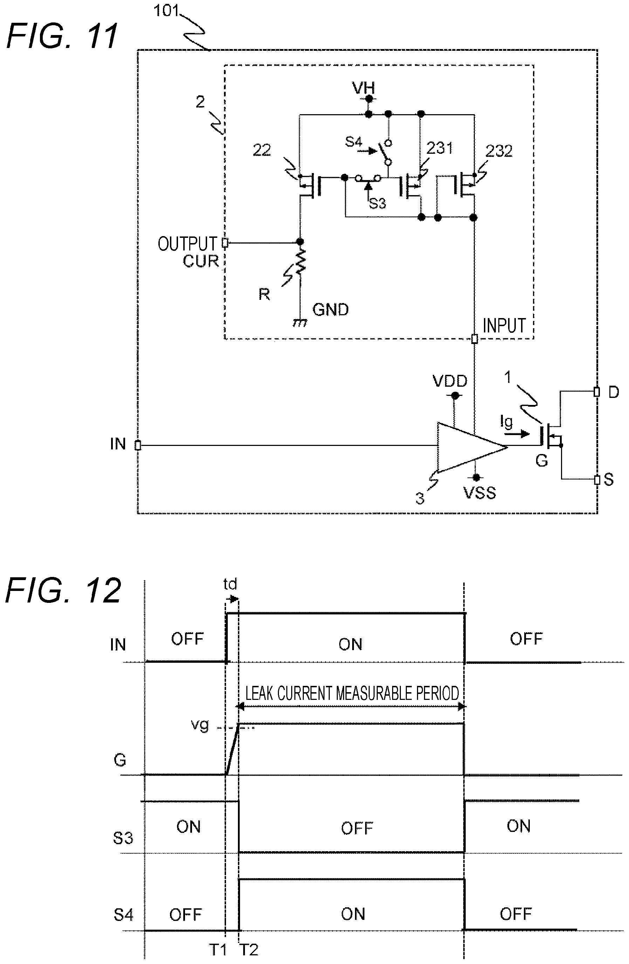

FIG. 11 is a block diagram illustrating an example of a configuration of the current measurement circuit 2 of a load driving device 101 according to a second embodiment of the present invention.

The current measurement circuit 2 illustrated in FIG. 11 includes the PMOS 22, a PMOS 231, a PMOS 232, the current detection resistor R, and a switch S3 and a switch S4 operated exclusively from each other. The current measurement circuit 2 receives current flowing from the power source VH via the gate driving circuit 3 into the gate terminal of the switching element 1, amplifies the current by means of a current mirror including the PMOS 22, the PMOS 231, and the PMOS 232, and converts and outputs the current into a voltage value CUR by means of the current detection resistor R. By changing input impedance of the current measurement circuit 2 by means of the switch S3 and the switch S4, sensitivity to input current of the current measurement circuit 2 can be changed. That is, when the switch S3 is in an on state while the switch S4 is in an off state, the input impedance of the current measurement circuit 2 and the sensitivity to input current of the current measurement circuit 2 are low, which is advantageous to a high-speed switching operation. Conversely, when the switch S3 is in an off state while the switch S4 is in an on state, the input impedance of the current measurement circuit 2 and the sensitivity to input current of the current measurement circuit 2 are high, which is advantageous to accurate measurement of minute current.

FIG. 12 is a timing chart illustrating an example of a circuit operation of the load driving device 101 according to the second embodiment of the present invention. When the IN terminal is in an off state, the switch S3 is in an on state while the switch S4 is in an off state, and the current measurement circuit 2 is in a state of having low input impedance and low sensitivity to input current. When the In terminal changes from OFF to ON at time T1, voltage of the gate terminal of the switching element 1 rises more quickly than that in the first embodiment since the input impedance of the current measurement circuit 2 is low. After the voltage of the gate terminal becomes stable at time T2, the switch S3 is turned off while the switch S4 is turned on. Since the current measurement circuit 2 gets in a state of having high input impedance and high sensitivity to input current, high-accuracy measurement of minute gate leak current is achieved, and detection accuracy of a failure of the gate oxide film is thus improved.

Switching timing between the switch S3 and the switch S4 can be after a lapse of a predetermined period td after the IN terminal changes from OFF to ON or can be after the voltage of the gate terminal becomes a predetermined voltage value vg.

As described above, the load driving device 101 described in the present embodiment is effective in further shortening turn-on time and can achieve high accuracy of the gate current measurement circuit.

### (Third Embodiment)

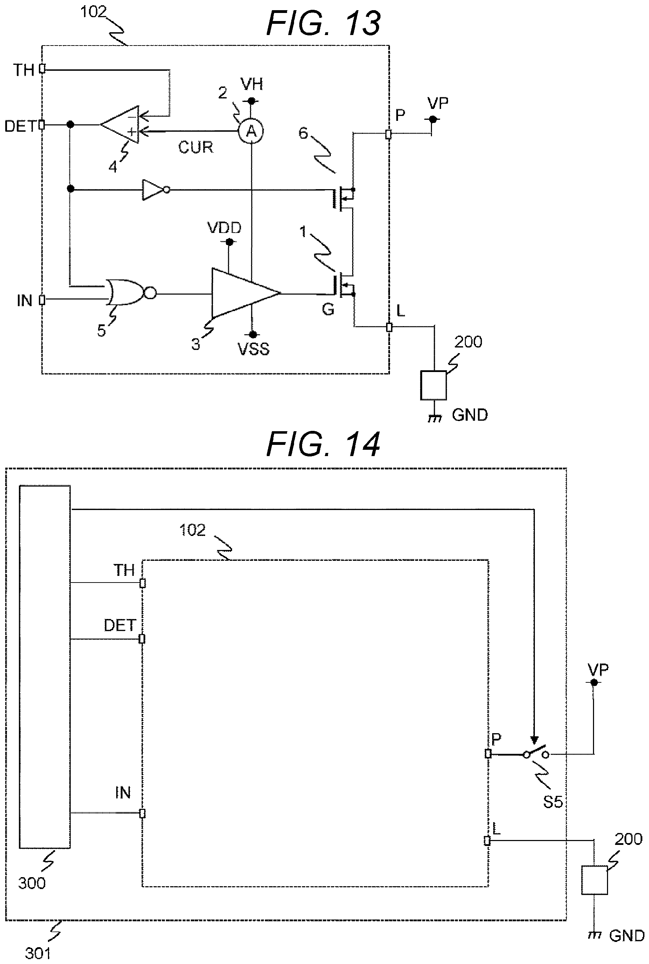

FIG. 13 is a block diagram illustrating an example of a configuration of a load driving device 102 according to a third embodiment of the present invention.

The load driving device 102 connected to a power source VP at a terminal P and connected to a load 200 at a terminal L includes the switching element 1, the gate driving circuit 3 connected at an input thereof to the IN terminal of the load driving device 102 to output voltage to the gate terminal G of the switching element 1, the current measurement circuit 2 configured to measure gate current Ig of the switching element 1 flowing via the gate driving circuit 3 from the power source VH, a gate leak current comparison circuit 4, in a case in which current measured by the current measurement circuit 2 is a predetermined leak current threshold value TH or higher, configured to output occurrence of a failure of the gate oxide film to a detection signal DET, a logic circuit 5 configured to turn off the switching element 1 in response to the detection signal DET of the gate leak current comparison circuit 4 regardless of the state of the input IN terminal of the load driving device 102, and a fail-safe switch 6 configured to disconnect the switching element 1 from the power source VP.

The leak current threshold value TH to be compared with a measurement value CUR of the current measurement circuit 2 in the gate leak current comparison circuit 4 can be determined in advance based on the size of the gate terminal of the switching element 1. When the output CUR of the current measurement circuit is the threshold value TH or higher, and a failure of the gate oxide film is detected, the switching element 1 is turned off regardless of the state of the input IN terminal, or the fail-safe switch 6 disconnects the switching element 1. Consequently, power supply to the switching element 1 is stopped, and the load driving device 102 can stop in a safe state.

Meanwhile, although the fail-safe switch 6 is an NMOS in the present embodiment, any element that can control disconnection and connection in accordance with the output result DET of the gate leak current comparison circuit 4 can be applied.

FIG. 14 is a block diagram illustrating an example of a load control device 301 using the load driving device 102 according to the present embodiment. The load control circuit 301 illustrated in FIG. 14 includes the load driving device 102, a control circuit 300, and a switch S5 located between the terminal P of the load driving device 102 and the power source VP and configured to control disconnection and connection in accordance with a signal from the control circuit 300.

The control circuit 300 outputs a control signal to the IN terminal of the load driving device 102 and receives the gate leak current comparison result DET of the load driving device 102. When the control circuit 300 detects a failure of the gate oxide film of the switching element 1 of the load driving device 102 based on the gate leak current comparison result DET, the control circuit 300 outputs a control signal to the IN terminal of the load driving circuit 102 to cause the switching element 1 to be turned off. Alternatively, by disconnecting the switch S5, the load control device 301 can stop in a safe state.

Although both control of turning off the switching element 1 and disconnection from the power source VP have been described in the present embodiment, the present invention is not limited to performing both the ways, and either way may be performed.

### (Fourth Embodiment)

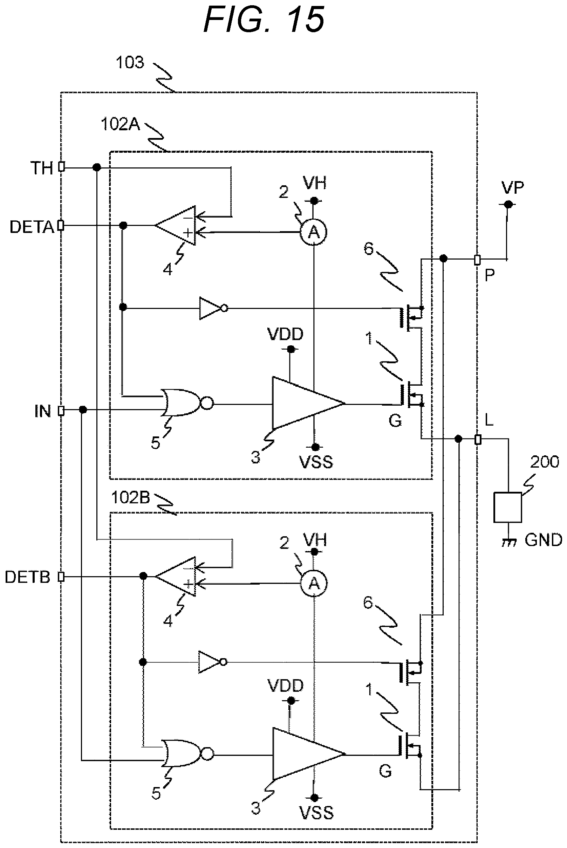

FIG. 15 is a block diagram illustrating an example of a configuration of a load driving device 103 according to a fourth embodiment of the present invention. The load driving device 103 connected to the power source VP at the terminal P and connected to the load 200 at the terminal L is configured to connect in parallel the two load driving devices 102 in FIG. 13 serving as a load driving device 102A and a load driving device 102B having the terminal P, the terminal L, and the IN terminal in common. That is, the load driving circuit 102A and the load driving circuit 102B simultaneously turn on/off the respective switching elements 1 to drive the same load. Since the load driving circuit 102A and the load driving circuit 102B respectively have the switching elements 1 and the current measurement circuits 2, the load driving circuit 102A and the load driving circuit 102B have the independent gate leak current comparison results DET. Accordingly, in a case in which a failure of the gate oxide film is detected in the switching element 1 of the load driving circuit 102A, for example, the switching element 1 of the load driving circuit 102A is turned off and is isolated from control by disconnecting the fail-safe switch 6, and only the load driving circuit 102B drives the load 200. The probability of a failure of the gate oxide film is proportional to the area of the switching element. Accordingly, by dividing a large-scale switching element into a plurality of switching elements and operating the load driving device by eliminating a failed switching element, it is possible to prevent the entire load driving device from being inoperable.

### (Fifth Embodiment)

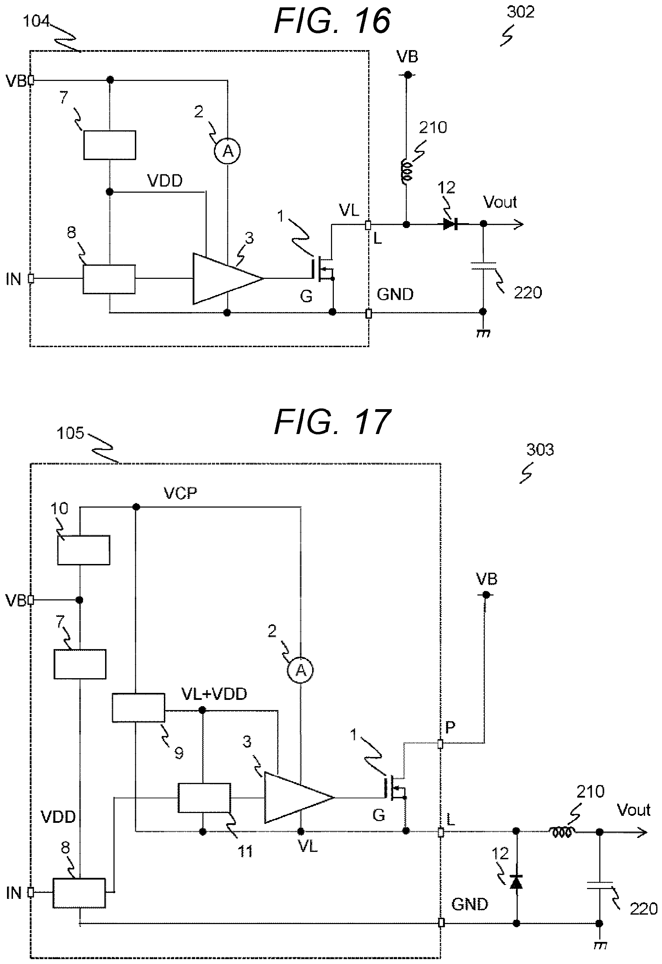

FIG. 16 is a block diagram illustrating an example of a configuration of a load driving device 104 according to a fifth embodiment of the present invention applied to a boost switching regulator 302 for an in-vehicle electronic control device. The boost switching regulator 302 illustrated in FIG. 16 includes the load driving device 104, an electromagnetic load 210, a diode 12, and a capacitor 220. The electromagnetic load 210 is connected at one side thereof to in-vehicle battery voltage VB and is connected at the other side thereof to the load connection terminal L of the load driving circuit 104 and an anode terminal of the diode 12. A cathode terminal of the diode 12 is connected to the capacitor 220 connected at one terminal thereof to GND and outputs voltage Vout from a voltage supply terminal. The load driving device 104 includes the switching element 1 connected at a drain thereof to the load connection terminal L and connected at a source thereof to the GND terminal, the gate driving circuit 3, the current measurement circuit 2, a built-in regulator 7, and a control logic circuit 8.

The built-in regulator 7 lowers the in-vehicle battery voltage VB and outputs VDD as applied gate voltage of the switching element 1 and power source voltage of the control logic circuit 8. The control logic circuit 8 is a logic circuit configured to convert a signal from the input IN terminal of the load driving device 104 into an on/off signal of the switching element 1. Although operations of the switching element 1, the gate driving circuit 3, and the current measurement circuit 2 are similar to those in the first to fourth embodiments, the current measurement circuit 2 is connected at one side thereof to the gate driving circuit 3 and is connected at the other side thereof to the in-vehicle battery voltage VB having higher potential than that of VDD.

According to the present embodiment, due to the load driving device 104 including the gate current measurement circuit enabling a high-speed switching operation, it is possible to provide the boost switching regulator 302 enabling an approximately-100-kHz switching operation and enabling detection of a failure of the gate oxide film. Meanwhile, although the current measurement circuit 2 is connected to the in-vehicle battery voltage VB in the present embodiment, a similar effect can be obtained even when the current measurement circuit 2 is connected to a power source producing higher voltage than the in-vehicle battery voltage VB or a power source producing voltage lower than the in-vehicle battery voltage VB and higher than the applied gate voltage VDD.

### (Sixth Embodiment)

FIG. 17 is a block diagram illustrating an example of a configuration of a load driving device 105 according to a sixth embodiment of the present invention applied to a buck switching regulator 303 for an in-vehicle electronic control device. The buck switching regulator 303 illustrated in FIG. 17 includes the load driving device 105, the electromagnetic load 210, the diode 12, and the capacitor 220. The electromagnetic load 210 is connected at one side thereof to the load connection terminal L of the load driving device 105 and the cathode terminal of the diode 12 and is connected at the other side thereof to the capacitor 220 and outputs voltage Vout from the voltage supply terminal. The anode terminal of the diode 12 is connected to GND and supplies freewheeling current from GND. The load driving device 105 includes the switching element 1 connected at the drain thereof to the in-vehicle battery voltage VB and connected at the source thereof to the load connection terminal L, the gate driving circuit 3, the current measurement circuit 2, the control logic circuit 8 serving as a logic circuit configured to convert a signal from the input IN terminal of the load driving device 105 into an on/off signal of the switching element 1, the built-in regulator 7 configured to output VDD from the in-vehicle battery voltage VB as applied gate voltage of the switching element 1 and power source voltage of the control logic circuit 8, a boost power source 10 such as a charge pump configured to output power VCP obtained by boosting the in-vehicle battery voltage VB, a power source 9 configured to use the power VCP to output voltage having potential obtained by boosting the potential VL of the load connection terminal L as much as VDD, and a level shift circuit 11 configured to perform logical voltage level conversion between an output of the control logic circuit 8 and an input of the gate driving circuit 3.

Although operations of the switching element 1, the gate driving circuit 3, and the current measurement circuit 2 are similar to those in the first to fifth embodiments, the current measurement circuit 2 is connected at one side thereof to the gate driving circuit 3 and is connected at the other side thereof to the boosted voltage VCP having higher potential than that of VL + VDD.

According to the present embodiment, due to the load driving device 105 including the gate current measurement circuit enabling a high-speed switching operation, it is possible to provide the buck switching regulator 303 enabling an approximately-100-kHz switching operation and enabling detection of a failure of the gate oxide film.

The present invention is not limited to the foregoing embodiments and includes various modification examples. For example, the foregoing embodiments have been described in detail to facilitate understanding of the present invention, and the present invention is not limited to one including all of the components described herein. Also, some components of one embodiment can be substituted with components of another embodiment, and components of another embodiment can be added to components of one embodiment. Further, some components of each embodiment can be added, deleted, and substituted with other components. Also, control lines and data lines deemed to be required in the description are shown, and not all control lines or data lines required for a product are shown. For example, although the switching element 1 is a MOSFET in the description of the present invention, a similar effect can be obtained even in a case in which the switching element 1 is an IGBT. Also, although the switching element 1 is an NMOS in the second and subsequent embodiments, a similar effect can be obtained even in a case in which the switching element 1 is a

### PMOS.

Also, the respective components in the load driving device described above may be formed on the same semiconductor chip to constitute an integrated circuit or may be separated as a plurality of parts. How the components are formed is not limited.

### Reference Signs List

- 1: switching element
- 2: current measurement circuit
- 3: gate driving circuit
- 4: gate leak current comparison circuit
- 5: logic circuit
- 6: fail-safe element
- 7: buck power source circuit
- 8: internal logic circuit
- 9, 10: boost power source circuit
- 11: level shift circuit
- 12: diode
- 100 to 105: load driving device
- 200: load
- 210: electromagnetic load
- 220: capacitor
- 300: control circuit
- 301: load control device
- 302, 303: switching regulator

## Claims

1. A load driving device driving a load by controlling ON/OFF of a switching element (1) connected to the load, by applying voltage to a gate terminal (G) of the switching element (1), the load driving device comprising:
the switching element (1);
a gate driving circuit (3) configured to apply a gate voltage to the switching element (1); and
a current measurement circuit (2) connected between a power source (VH) and a power input of the gate driving circuit (3), and configured to measure current flowing from the power source (VH) via the gate terminal (G) to the switching element (1),
wherein the gate driving circuit (3) comprises a voltage application circuit(31), where the voltage application circuit (31) is connected to the power input of the gate driving circuit (3) and to a reference power source (VDD) provided as a reference; and the voltage application circuit(31) is configured to output a voltage having a potential equal or lower to that of the reference voltage (VDD);
wherein the power source (VH) has a higher voltage than that of the reference voltage (VDD);
and wherein the gate voltage is restricted by the voltage of the output of the voltage application circuit(31) .

2. The load driving device according to claim 1, wherein the voltage value of the power source is an in-vehicle battery voltage or a voltage obtained by boosting the in-vehicle battery voltage.

3. The load driving device according to claim 1, wherein the current measurement circuit (2) comprises switches which are adapted to switch between setting in which input impedance and sensitivity to input current are high and setting in which input impedance and sensitivity to input current are low, wherein the current measurement circuit (2) is configured that in a period of measuring current flowing via the gate terminal of the switching element (1), the setting in which input impedance and sensitivity to input current are high, is selected.

4. The load driving device according to claim 1, which is further configured that a lapse of a predetermined period from turn-on or turn-off triggers measurement of current flowing via the gate terminal of the switching element (1).

5. The load driving device according to any one of claims 1 to 4, comprising:
a gate leak current comparison circuit (4) configured to receive a current value of current flowing via the gate terminal of the switching element (1) output by the current measurement circuit and a predetermined gate leak current threshold value,
wherein, in a case in which the current value output by the current measurement circuit is the gate leak current threshold value or higher, the comparison circuit outputs a gate leak detection signal.

6. The load driving device according to claim 5, which is further configured that when the gate leak current comparison circuit (4) outputs the gate leak detection signal, the gate terminal of the switching element (1) is fixed to an off state regardless of a state of control of the switching element (1) .

7. The load driving device according to claim 5, comprising:
a fail-safe switch between the switching element (1) and the power source or between the switching element (1) and the load,
wherein the load driving device is further configured that when the gate leak current comparison circuit outputs the gate leak detection signal, the fail-safe switch is disconnected.

8. A load driving device comprising:
a plurality of load driving devices each according to any one of claims 6 to 7 connected in parallel to a driven load,
wherein, among the load driving devices connected in parallel, the load driving device that outputs the gate leak detection signal is disconnected and isolated from control, and an operation is maintained by the load driving devices that are normal.

9. An in-vehicle control device (301) comprising:
the load driving device according to any one of claims 5 to 8; and
a control circuit (300) configured to control the load driving device,
wherein the control circuit is configured to fix a control signal of the load driving device (301) to an off state in response to a gate leak detection signal of the load driving device (301).

10. The in-vehicle control device according to claim 9, comprising:
a fail-safe switch between the load driving circuit and a power source or between the load driving circuit and a load,
wherein the control circuit is configured to disconnect the fail-safe switch in response to the gate leak detection signal of the load driving circuit.

11. The load driving device according to any one of claims 1 to 8,
wherein the load driving device is an integrated circuit formed on a same semiconductor chip and implemented on a same package.

12. An in-vehicle control device comprising a load driving device according to any of claims 1 to 7
and a control circuit (300) configured to control the gate driving circuit (3).

## Patentansprüche

1. Lastansteuervorrichtung, die durch Steuern von EIN/AUS eines Schaltelements (1), das mit der Last verbunden ist, eine Last ansteuert, indem eine Spannung an einen Gate-Anschluss (G) des Schaltelements (1) angelegt wird, wobei die Lastansteuervorrichtung Folgendes umfasst:
das Schaltelement (1);
eine Gate-Ansteuerschaltung (3), die konfiguriert ist, eine Gate-Spannung an das Schaltelement (1) anzulegen; und
eine Strommessschaltung (2), die zwischen eine Stromquelle (VH) und einen Leistungseingang der Gate-Ansteuerschaltung (3) geschaltet ist und konfiguriert ist, einen Strom zu messen, der von der Stromquelle (VH) über den Gate-Anschluss (G) zum Schaltelement (1) fließt,
wobei die Gate-Ansteuerschaltung (3) eine Spannungsanlegeschaltung (31) umfasst, wobei die Spannungsanlegeschaltung (31) mit dem Leistungseingang der Gate-Ansteuerschaltung (3) und mit einer Referenzstromquelle (VDD), die als eine Referenz vorgesehen ist, verbunden ist; und die Spannungsanlegeschaltung (31) konfiguriert ist, eine Spannung auszugeben, die ein Potential aufweist, das kleiner oder gleich demjenigen der Referenzspannung (VDD) ist;
wobei die Stromquelle (VH) eine höhere Spannung als diejenige der Referenzspannung (VDD) aufweist; und
wobei die Gate-Spannung durch die Spannung des Ausgangs der Spannungsanlegeschaltung (31) begrenzt wird.

2. Lastansteuervorrichtung nach Anspruch 1, wobei der Spannungswert der Stromquelle eine Fahrzeugbordbatteriespannung oder eine Spannung, die durch Verstärken der Fahrzeugbordbatteriespannung erhalten wird, ist.

3. Lastansteuervorrichtung nach Anspruch 1, wobei die Strommessschaltung (2) Schalter umfasst, die ausgelegt sind, zwischen einer Einstellung, in der eine Eingangsimpedanz und eine Empfindlichkeit für einen Eingangsstrom hoch sind, und einer Einstellung, in der die Eingangsimpedanz und die Empfindlichkeit für einen Eingangsstrom niedrig sind, umzuschalten, wobei die Strommessschaltung (2) derart konfiguriert ist, dass in einem Zeitraum des Messens des Stroms, der über den Gate-Anschluss des Schaltelements (1) fließt, die Einstellung, in der die Eingangsimpedanz und die Empfindlichkeit für einen Eingangsstrom hoch sind, ausgewählt wird.

4. Lastansteuervorrichtung nach Anspruch 1, die ferner derart konfiguriert ist, dass ein Verstreichen eines vorgegebenen Zeitraums beginnend beim Einschalten oder Ausschalten eine Messung des Stroms, der über den Gate-Anschluss des Schaltelements (1) fließt, auslöst.

5. Lastansteuervorrichtung nach einem der Ansprüche 1 bis 4, die Folgendes umfasst:
eine Gate-Leckstrom-Vergleichsschaltung (4), die konfiguriert ist, einen Stromwert des Stroms, der über den Gate-Anschluss des Schaltelements (1) fließt, der durch die Strommessschaltung ausgegeben wird, und einen vorgegebenen Gate-Leckstrom-Schwellenwert zu empfangen,
wobei dann, wenn der Stromwert, der durch die Strommessschaltung ausgegeben wird, gleich dem Gate-Leckstrom-Schwellenwert oder höher ist, die Vergleichsschaltung ein Gate-Leck-Detektionssignal ausgibt.

6. Lastansteuervorrichtung nach Anspruch 5, die ferner derart konfiguriert ist, dass dann, wenn die Gate-Leckstrom-Vergleichsschaltung (4) das Gate-Leck-Detektionssignal ausgibt, der Gate-Anschluss des Schaltelements (1) ungeachtet eines Zustands der Steuerung des Schaltelements (1) auf einem Aus-Zustand festgelegt wird.

7. Lastansteuervorrichtung nach Anspruch 5, die Folgendes umfasst:
einen Sicherheitsschalter zwischen dem Schaltelement (1) und der Stromquelle oder zwischen dem Schaltelement (1) und der Last,
wobei die Lastansteuervorrichtung ferner konfiguriert ist, dass dann, wenn die Gate-Leckstrom-Vergleichsschaltung das Gate-Leck-Detektionssignal ausgibt, der Sicherheitsschalter getrennt wird.

8. Lastansteuervorrichtung, die Folgendes umfasst:
mehrere Lastansteuervorrichtungen, jeweils nach einem der Ansprüche 6 bis 7, die zu einer angesteuerten Last parallel geschaltet sind,
wobei von den parallel geschalteten Lastansteuervorrichtungen die Lastansteuervorrichtung, die das Gate-Leck-Detektionssignal ausgibt, von der Steuerung getrennt und isoliert wird und ein Betrieb durch die Lastansteuervorrichtungen, die regulär sind, aufrechterhalten wird.

9. Fahrzeugbord-Steuervorrichtung (301), die Folgendes umfasst:
die Lastansteuervorrichtung nach einem der Ansprüche 5 bis 8; und
eine Steuerschaltung (300), die konfiguriert ist, die Lastansteuervorrichtung zu steuern,
wobei die Steuerschaltung konfiguriert ist, ein Steuersignal der Lastansteuervorrichtung (301) als Antwort auf ein Gate-Leck-Detektionssignal der Lastansteuervorrichtung (301) auf einen Aus-Zustand festzulegen.

10. Fahrzeugbord-Steuervorrichtung nach Anspruch 9, die Folgendes umfasst:
einen Sicherheitsschalter zwischen der Lastansteuerschaltung und einer Stromquelle oder zwischen der Lastansteuerschaltung und einer Last,
wobei die Steuerschaltung konfiguriert ist, den Sicherheitsschalter als Antwort auf das Gate-Leck-Detektionssignal der Lastansteuerschaltung zu trennen.

11. Lastansteuervorrichtung nach einem der Ansprüche 1 bis 8,
wobei die Lastansteuervorrichtung eine integrierte Schaltung ist, die aus demselben Halbleiterchip gebildet ist und auf demselben Gehäuse implementiert ist.

12. Fahrzeugbord-Steuervorrichtung, die eine Lastansteuervorrichtung nach einem der Ansprüche 1 bis 7
und eine Steuerschaltung (300), die konfiguriert ist, die Gate-Ansteuerschaltung (3) zu steuern, umfasst.

## Revendications

1. Dispositif de pilotage de charge pilotant une charge par commande de marche/arrêt (ON/OFF) d'un élément de commutation (1) connecté à la charge, en appliquant une tension à une borne de grille (G) de l'élément de commutation (1), le dispositif de pilotage de charge comprenant :
l'élément de commutation (1) ;
un circuit de pilotage de grille (3) configuré pour appliquer une tension de grille à l'élément de commutation (1) ; et
un circuit de mesurage de courant (2) connecté entre une source de puissance (VH) et une entrée de puissance du circuit de pilotage de grille (3), et configuré pour mesurer un courant s'écoulant depuis la source de puissance (VH) via la borne de grille (G) jusqu'à l'élément de commutation (1),
dans lequel le circuit de pilotage de grille (3) comprend un circuit d'application de tension (31), le circuit d'application de tension (31) étant connecté à l'entrée de puissance du circuit de pilotage de grille (3) et à une source de puissance de référence (VDD) prévue comme référence ; et le circuit d'application de tension (31) étant configuré pour sortir une tension ayant un potentiel égal ou inférieur à celui de la tension de référence (VDD) ;
dans lequel la source de puissance (VH) a une tension plus élevée que celle de la tension de référence (VDD) ;
dans lequel la tension de grille est restreinte par la tension de la sortie du circuit d'application de tension (31).

2. Dispositif de pilotage de charge selon la revendication 1, dans lequel la valeur de tension de la source de puissance est une tension de batterie embarquée dans un véhicule ou une tension obtenue en amplifiant la tension de batterie embarquée dans un véhicule.

3. Dispositif de pilotage de charge selon la revendication 1, dans lequel le circuit de mesurage de courant (2) comprend des commutateurs qui sont adaptés pour commuter entre un réglage dans lequel une impédance d'entrée et une sensibilité à un courant d'entrée sont élevées et un réglage dans lequel une impédance d'entrée et une sensibilité à un courant d'entrée sont faibles, dans lequel le circuit de mesurage de courant (2) est configuré de telle sorte que, dans une période de mesurage d'un courant s'écoulant via la borne de grille de l'élément de commutation (1), le réglage dans lequel une impédance d'entrée et une sensibilité à un courant d'entrée sont élevées est sélectionné.

4. Dispositif de pilotage de charge selon la revendication 1, qui est en outre configuré de telle sorte qu'un écoulement d'une période prédéterminée à partir d'une activation ou d'une désactivation déclenche un mesurage d'un courant s'écoulant via la borne de grille de l'élément de commutation (1).

5. Dispositif de pilotage de charge selon l'une quelconque des revendications 1 à 4, comprenant :
un circuit de comparaison de courant de fuite de grille (4) configuré pour recevoir une valeur actuelle d'un courant s'écoulant via la borne de grille de l'élément de commutation (1) sortie par le circuit de mesurage de courant et une valeur seuil de courant de fuite de grille prédéterminée,
dans lequel, dans un cas où la valeur actuelle sortie par le circuit de mesurage de courant est la valeur seuil de courant de fuite de grille ou une valeur plus élevée, le circuit de comparaison sort un signal de détection de fuite de grille.

6. Dispositif de pilotage de charge selon la revendication 5, qui est en outre configuré de telle sorte que, quand le circuit de comparaison de courant de fuite de grille (4) sort le signal de détection de fuite de grille, la borne de grille de l'élément de commutation (1) est fixée à un état d'arrêt indépendamment d'un état de commande de l'élément de communication (1).

7. Dispositif de pilotage de charge selon la revendication 5, comprenant :
un commutateur de sécurité entre l'élément de commutation (1) et la source de puissance ou entre l'élément de commutation (1) et la charge,
dans lequel le dispositif de pilotage de charge est en outre configuré de telle sorte que, quand le circuit de comparaison de courant de fuite de grille sort le signal de détection de fuite de grille, le commutateur de sécurité est déconnecté.

8. Dispositif de pilotage de charge comprenant :
une pluralité de dispositifs de pilotage de charge, chacun selon l'une quelconque des revendications 6 à 7, connectés en parallèle à une charge pilotée,
dans lequel, parmi les dispositifs de pilotage de charge connectés en parallèle, le dispositif de pilotage de charge qui sort le signal de détection de fuite de grille est déconnecté et isolé de la commande, et un fonctionnement est maintenu par les dispositifs de pilotage de charge qui sont normaux.

9. Dispositif de commande embarqué dans un véhicule (301) comprenant :
le dispositif de pilotage de charge selon l'une quelconque des revendications 5 à 8 ; et
un circuit de commande (300) configuré pour commander le dispositif de pilotage de charge,
dans lequel le circuit de commande est configuré pour fixer un signal de commande du dispositif de pilotage de charge (301) à un état d'arrêt en réponse à un signal de détection de fuite de grille du dispositif de pilotage de charge (301).

10. Dispositif de commande embarqué dans un véhicule selon la revendication 9, comprenant :
un commutateur de sécurité entre le circuit de pilotage de charge et une source de puissance ou entre le circuit de pilotage de charge et une charge, dans lequel le circuit de commande est configuré pour déconnecter le commutateur de sécurité en réponse au signal de détection de fuite de grille du circuit de pilotage de charge.

11. Dispositif de pilotage de charge selon l'une quelconque des revendications 1 à 8,
dans lequel le dispositif de pilotage de charge est un circuit intégré formé sur une même puce semi-conductrice et implémenté sur un même boîtier.

12. Dispositif de commande comprenant un dispositif de pilotage de charge selon l'une quelconque des revendications 1 à 7,
et un circuit de commande (300) configuré pour commander le circuit de pilotage de grille (3).
